# EUROPEAN PATENT SPECIFICATION

(11) **EP 0 532 925 B1**
(45) Date of publication and mention of the grant of the patent: **15.01.1997**
(21) Application number: 92114177.6
(22) Date of filing: 20.08.1992
(51) Int. Cl.: G01R 1/073, G01R 31/28

(54) **Rigid-flex circuits with raised features as IC test probes**
Starre-flexible Leiterplatten mit Erhöhungen als IC-Prüfspitzen
Circuit rigids-flexibles avec contacts surélevés tels que sondes de test pour circuits integrés

(30) Priority: 26.08.1991 US 749770; 30.08.1991 US 752422
(43) Date of publication of application: 24.03.1993
(73) Proprietor: Hughes Aircraft Company, Los Angeles, California 90045-0066 (US)
(72) Inventor: Woith, Blake F., Orange, California 92669 (US); Crumly, William R., Anaheim, California 92807 (US); Linder, Jacques F., Rancho Palos Verdes, California 90274 (US)
(74) Representative: Witte, Alexander, Dr.-Ing.

(56) References cited:
- EP-A- 0 259 163
- EP-A- 0 294 939
- EP-A- 0 331 282
- FR-A- 2 617 290
- US-A- 4 972 143

## Description

The present invention relates to a device for testing an electrical circuit element having contacts thereon in a predetermined pattern, comprising a mounting fixture, a membrane assembly, said membrane assembly comprising a flexible membrane, a plurality of contacts on one side of said membrane, corresponding in position to the pattern of contacts on said electrical circuit element, circuit means on said membrane connected to said contacts and extending away from said contacts for connection to a test circuit, means for detachably positioning and supporting said membrane assembly relative to said mounting fixture, a support form engaging the opposite side of said membrane, means for holding said support form on said mounting fixture in a predetermined fixed position, and means for positioning said support form so that said support form engages said membrane and deflects said membrane outwardly.

The invention relates further to a method of constructing a circuit testing device, comprising the steps of providing a flexible membrane, positioning contact means on one side of said membrane in a pattern corresponding to that of contacts on a device to be tested, extending conductor means on said membrane for connection to a testing circuit, holding peripheral portions of said membrane such that intermediate portions of said membrane are unconstrained, engaging the opposite side of said intermediate portion of said membrane with a member such that said member deflects said membrane outwardly whereby the contact means on said membrane can engage said contacts of said device to be tested and whereby said member is engaged with said membrane at a location opposite from said contact means.

Such a device for testing and such a method of constructing a circuit testing device are known from EP-A-0 259 163.

From FR-A-2 617 290 another circuit testing device is known wherein a surface engaging said membrane is slightly curved.

This invention relates generally to the testing of integrated circuits or other items having a pattern of contacts thereon.

Integrated circuits or chips are manufactured with large numbers of identical circuits on a single wafer which ultimately are separately cut from the wafer for use. It is necessary to test each circuit individually to determine whether or not it functions as intended before separating it from the wafer.

Conventional testing employs a probe card which is provided with a large number of small tungsten blades or needles that are mechanically and electrically connected to a circuit board and act as contacts. Electrical leads extend from the contacts to the outer edge of the board for connecting the probe card to test circuitry. In use, the blades or needles are moved into engagement with the pads of an integrated circuit. This provides an electrical connection so that signals can be read to determine the integrity of the circuit on the chip.

The needles or blades must all fall in the same plane in order to assure that each one makes electrical contact with a pad of the integrated circuit. This is accomplished by bending the blades or needles after they are mounted on the probe card, which is laborious, time consuming and expensive. Even after such adjustment the blades or needles tend to creep back toward their original positions so that their adjusted locations are lost. This loss of adjustment also comes about from the pressure of the needles against the chips, aggravated by the scrubbing action used to assure penetration of any oxide coating. As a result, constant maintenance is necessary or the probe cards will not perform their intended function. Even when in proper adjustment, the needles cannot compensate for significant differences in the heights of the contact pads on the integrated circuit chips being tested. The needles also may apply excessive forces against the chips so as to damage the chips. The close spacing necessary for testing some chips cannot be achieved with conventional needle contacts.

An improved testing arrangement is disclosed in co-pending U.S. application Serial No. 606,676, filed October 31, 1990, by John Pasiencznik, Jr., for METHOD AND APPARATUS FOR TESTING INTEGRATED CIRCUITS assigned to the same assignee as that of this application. The corresponding European application EP-A-0 464 141 is a document falling under Art. 54(3) EPC. In this prior arrangement, a flexible membrane is provided with raised features on one side which connect through circuit traces to a probe card that, in turn, is connected into the test circuit. Air pressure is used to deflect the membrane as the contacts of the membrane are pressed against the pads of an integrated circuit to provide an electrical connection. There is room for improvement, however, in assuring that adequate pressure exists between the contacts on the membrane and the pads on the integrated circuit chip to assure a good electrical connection, while at the same time avoiding undesirable contact between remaining portions of the membrane and the chip.

The amount of pressure on the membrane in the earlier design is limited by its physical characteristics which in turn limit its ability to engage contacts on the chip which are not in the same plane. Advancement of the chip toward the membrane merely will deflect the membrane inwardly rather than causing all of the contacts to make engagement in some instances. Excessive drape of the membrane around the contacts may result. The membrane will be deflected to such an extent that it undesirably engages the chip around the contact rather than engaging only at the contacts.

In view of the above prior art, it is the object of the invention to provide an improved device for testing an electrical surface element and an improved method of constructing a circuit testing device.

The above object is achieved by a device for testing an electrical surface element, mentioned at the outset, wherein a contoured surface having a pattern of ridges engages said membrane such that said contacts on said membrane can be pressed against contacts of said electrical circuit element.

The above object is further achieved by a method of constructing a circuit testing device, mentioned at the outset, wherein said member is provided with a contoured surface having a pattern of ridges which surface can be engaged with said membrane.

The present invention provides generally an improved arrangement for testing integrated circuit chips or the like which utilizes a combination of a membrane having contacts on one side for engagement with the pads of an integrated circuit chip, together with a support form on the other side of the membrane to direct the force applied by the membrane.

In one version, the support form is a pliable soft pad of a transparent elastomer that is mechanically clamped so that it causes the membrane to be distended for applying a force between the membrane contacts and the pads of the integrated circuit chip. The support form may have a pattern of ridges, all in the same plane, on the surface that engages the membrane. The ridges are positioned opposite from the contacts so that they can concentrate the force applied by the contacts. The item to be tested is positioned below the membrane on a work table which can move horizontally as well as vertically relative to the membrane. The operator can sight through the transparent support pad, as well as through a transparent window in the membrane, to align the contacts of the membrane with pads on the integrated circuit chip.

As a result, an effective electrical connection can be accomplished very easily with assurance that the contacts all will be brought into engagement with the chip. If there is some variation in the height of the pads on the chip, the pliable support form will compensate for this allowing some contacts to extend farther than others to make the necessary engagement. This is accomplished without the use of excessive localized force so that damage to the chip is avoided. By concentrating the force on the membrane at the location of the raised features, the membrane will not drape around the contacts to make undesirable engagement with the chip at locations other than the contacts. The raised features on the membrane may be as closely spaced as necessary to correspond to the pattern of contact pads on any integrated circuit chip.

In another embodiment the support form has ridges that straddle the locations of the contacts so that the contacts are forced against the pads on the chip from either side. Again, compensation is possible for variation in the height of the pads on the chip.

In a further embodiment the support pad has a flat bottom surface and may be of a rigid material such as glass.
FIG. 1 is an exploded perspective view of the circuit testing arrangement of this invention;
FIG. 2 is a transverse sectional view taken along line 2-2 of FIG. 6;
FIG. 3 is an enlarged fragmentary exploded perspective view showing the support form, membrane and an integrated circuit chip to be tested;
FIG. 4 is an enlarged fragmentary sectional view illustrating the deflection of the membrane by the support form;
FIG. 5 is a view similar to FIG. 4 including a modified support form;
FIG. 6 is a bottom plan view of the circuit testing device;
FIG. 7 is an enlarged fragmentary sectional view of the membrane assembly;
FIG. 8 is an enlarged fragmentary view illustrating the zone where the membrane assembly engages the probe card; and
FIG. 9 is a transverse sectional view illustrating the device with a modified support form, not belonging to the present invention.

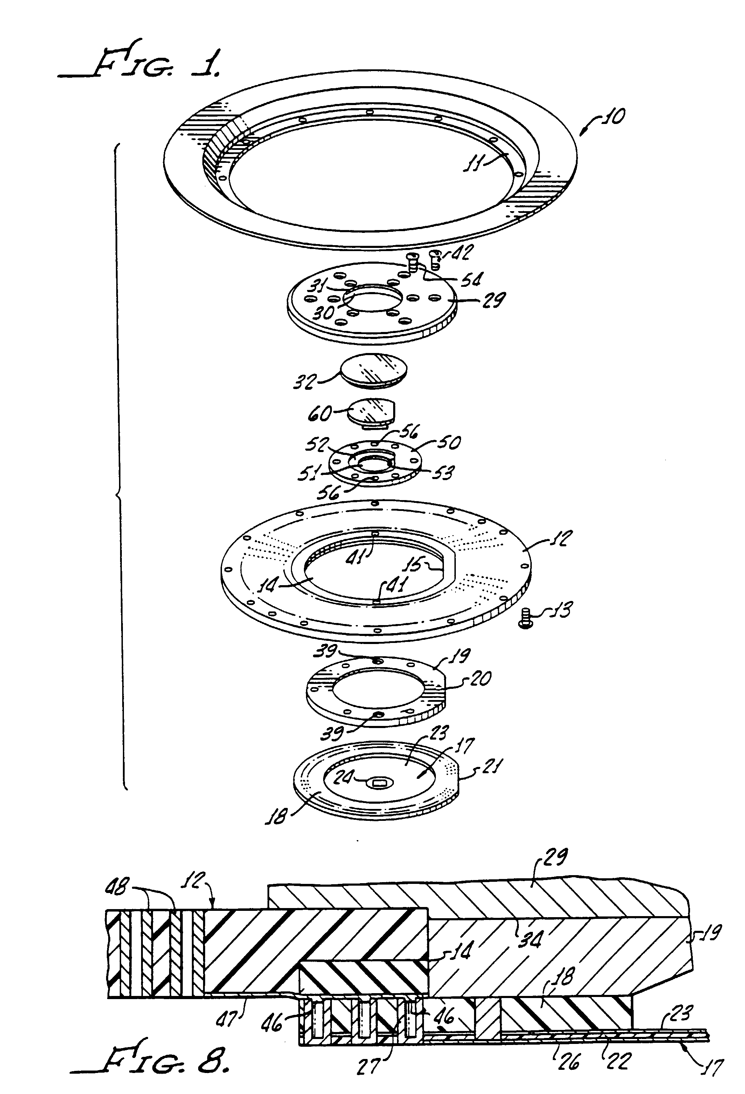

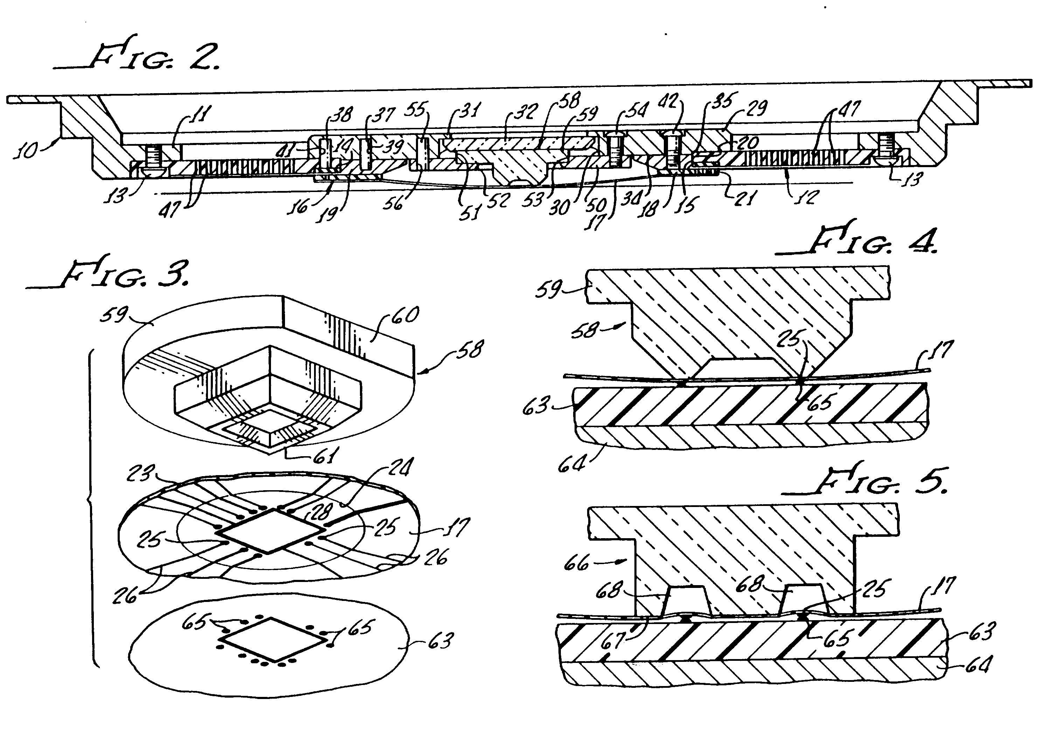

The test fixture of this invention includes a rigid annular frame 10 having a flange 11 around its inner peripheral edge to which is connected a probe card 12 by means of screws 13. The probe card 12 is a form of printed circuit board that includes a rigid dielectric member which carries circuit traces and contact elements. An opening 14 in the probe card 12 is circular except for a flat 15 to assist in aligning the other components of the fixture.

Positioned beneath the probe card is a membrane assembly 16 which consists of a flexible membrane 17 around the periphery of which is a rigid ring 18 of dielectric material. Bonded to one side of the ring 18 is a thicker annular member 19 of dielectric material which leaves the central portion of the membrane exposed. A flat 20 is provided on the otherwise circular periphery of the annular member 19 just as a flat 21 is located on the periphery of the diaphragm assembly 16. These flats are used for alignment purposes. The flat 21 is radially farther from the center of the assembled unit than is the flat 20.

The membrane 17 is of laminated construction including a layer of transparent polymide 22 on one side of which (the upper side, as shown) is a layer of copper 23 which acts as a grounding plane. A central opening 24 in the copper layer 23 exposes the polymide layer. On the opposite side of the polymide layer 22 at its central portion are raised features 25 which are gold plated. These contacts are in the exact pattern of contact pads on an integrated circuit chip to be tested and can be seen from above through the opening 24 in the layer 23. Conductors 26 extend outwardly in the radial direction from the raised features 25. The conductors 26 connect to plated through holes 27 around the periphery of the membrane 17 at the location of the rigid disk 18. A grounding bus 28 also is included within the gold dots 25.

On the upper side of the probe card 12, as the device is illustrated, is a disk 29, which may be made of aluminum, having a central opening 30 into which projects a narrow flange 31. A glass window 32 is bonded to the member 29 at the opening 30, butting against the underside of the flange 31. The bottom surface of the disk 29 is recessed around its outer edge to provide a central projection 34 which has a periphery generally complementary to the opening 14 in the probe card 12. The projecting portion 34 extends down into the opening 14 in the probe card, and includes a flat 35 which indexes the disk 29 rotationally with the probe card.

The annular member 19 extends into the opening 14 from the lower side with its flat 20 also indexing the membrane assembly 16 rotationally with the probe card 12.

Precise alignment of the disk 29 and membrane 17 is accomplished by two pairs of diametrically opposite pins 37 and 38 which project downwardly from the disk 29. The inner pair of pins 37 enters openings 39 in the annular member 19. The outer pair of pins 38 extends into diametrically opposite openings 41 in the probe card 12. Therefore, the membrane assembly 16 is aligned with the disk 29 and the latter member is aligned with the probe card 12, resulting in alignment between the membrane and the probe card. Screws 42 extend through in the disk 29 and into the annular member 19 to hold the components together.

In the assembled relationship, the contacts 27 of the membrane assembly bear against contacts 46 around the inner periphery of the probe card 12. The latter contacts connect through circuit traces 47 to contacts 48 outwardly on the probe card, which in turn mate with conductive elements in the testing instrument, not shown.

Connected to the underside of the disk 29 is a retainer 50 in the form of a flat disk having a circular central opening 51, recessed at its upper end to provide an inner peripheral flange 52 and a flat 53. Screws 54 connect the retainer 50 to the disk 29, while alignment pins 55 on the disk 29 extend into openings 56 in the retainer to position the retainer relative to the disk.

A support form 58 is positioned above the membrane 17 and held by the retainer 50. The support form 58 is a pad of transparent material, such as a clear silicone rubber, and is soft, having a shore A hardness in the range of 40 to 60. At the upper end of the form 58 is a flange 59 which fits complementarily within the opening 51 in the retainer 50 above the flange 52. The flange 59 of the support form is held between the glass window 32 and the flange 52, indexed rotationally by a flat 60 on the support form that is positioned against the flat 53 of the opening 51.

Beneath the flange 59, the support form 58 is relatively thick and tapers downwardly to an annular rectangular bottom edge 61 that is entirely within a horizontal plane, as the device is illustrated. The edge 61 provides a ridge that has the same shape as the pattern of the raised features 25 on the bottom of the membrane 17. The support form 58 is rotationally aligned by the retainer 50 so that its bottom edge 61 is opposite from the raised features 25. With the support form 58 clamped in position by the retainer 50 the bottom edge of the form deflects the membrane 17 outwardly beneath the probe card 12.

In use of the device of this invention, an integrated circuit chip 63 is positioned on a horizontal table 64 which has provision for movement in the X-Y plane and also Z axis movement. The operator visually sights, with the aid of a microscope, through the glass window 32, the support form 58 and the opening 24 and manipulates the table 64 so that the contact pads 25 on the membrane are aligned with the contacts 65 on the integrated circuit chip 63. The table 64 is moved toward the test fixture so that the contacts 25 of the membrane engage the contacts 65 of the integrated circuit chip and form electrical connections therewith. This is readily accomplished with the membrane 17 being distended in the direction of the table 64 by the support form 58. Sufficient relative advancement of the table 64 is accomplished to cause the mating contacts to press firmly against each other.

The support form not only deflects the membrane 17 outwardly to engage the integrated circuit chip, but also provides a means for applying uniform pressure against all of the contacts 25 to assure a good electrical connection with the chip. By being soft and compliant, the support form 58 can allow for limited over-travel in certain locations. This is important in the event that all of the contacts 65 on the integrated circuit chip 63 are not entirely within the same plane. The support form 58 will push the membrane 17 into locations where the contacts on the chip may be recessed to accomplish an electrical connection. Adequate force may be applied to achieve the electrical connection without damaging the chip. The pattern of the bottom edge 61 of the support form 58, following that of the contacts 25 on the membrane and of the contacts 65 on the integrated circuit chip, concentrates the force of the membrane against the contacts which are to be brought into engagement with each other. By localizing the force on the membrane 17, the drape of the flexible circuit around the IC chip is minimized. In other words, there is not much tendency for the membrane to be deflected past the contact pads on the chip to engage the chip at other locations.

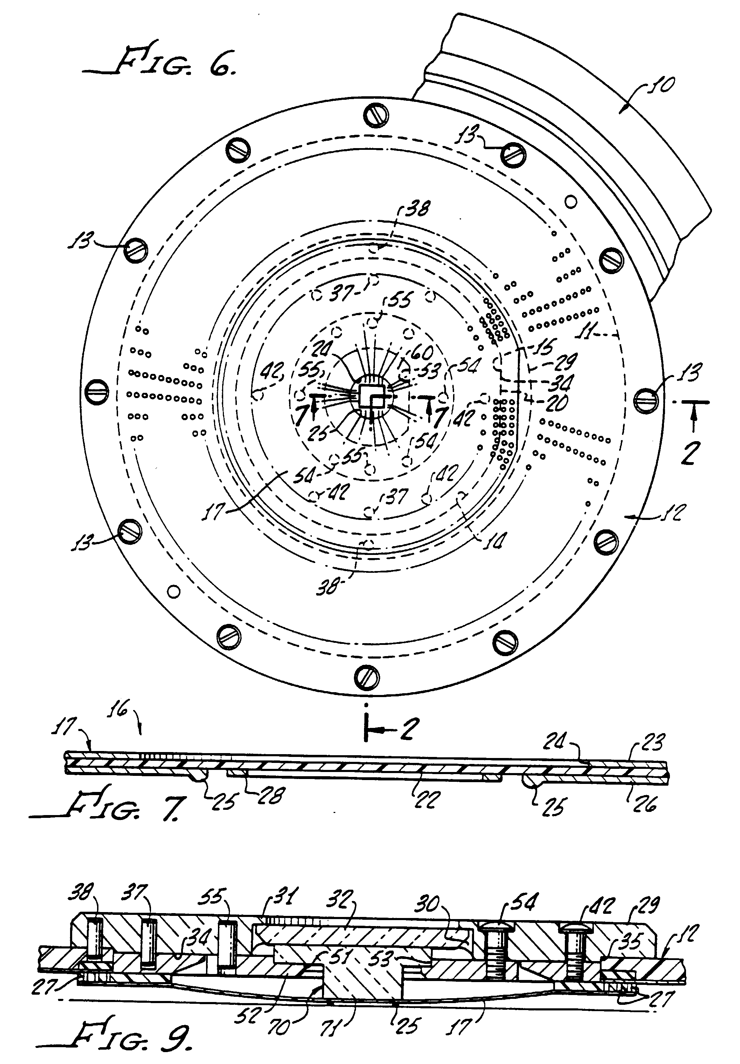

In the embodiment of Fig. 5, the support form 66 has a flat bottom edge 67 with recesses 68 above the contacts 25 of the membrane 17. As a result, the membrane is pulled slightly down around the contacts of the integrated circuit chip, again assuring intimate contact between the contacts 25 and those of the integrated circuit chip. This engagement between the mating contact will occur even if the contacts of the integrated circuit chip are not entirely within a single plane. Excessive drape of the membrane 17 is avoided.

In the embodiment of Fig. 9, not belonging to the present invention the support form 70 has a planar bottom surface 71 without ridges or recesses. In this instance the support form 70 also is rigid and may be made of glass or a transparent plastic. The support form 70 applies a uniform force against the contacts while avoiding drape of the membrane 17.

The support forms 58 and 66 also may be made of rigid material for certain installations. Also, the size of the support forms of compliant material may be varied so as to provide a relatively thin pad behind the membrane. The support form will nevertheless be confined along its upper surface, such as by the glass window 32.

## Claims

1. Device for testing an electrical circuit element (63) having contacts (65) thereon in a predetermined pattern comprising
a mounting fixture (10),
a membrane assembly (16), said membrane assembly (16) comprising
a flexible membrane (17),
a plurality of contacts (25) on one side of said membrane (17), corresponding in position to the pattern of contacts (65) on said electrical circuit element (63),
circuit means (26) on said membrane (17) connected to said contacts (25) and extending away from said contacts (25) for connection to a test circuit,
means (19, 29) for detachably positioning and supporting said membrane assembly (16) relative to said mounting fixture (10),
a support form (58, 66) engaging the opposite side of said membrane (17),
means (29, 32, 50) for holding said support form (58, 66) on said mounting fixture (10) in a predetermined fixed position, and
means (64) for positioning said support form (58, 66) so that said support form (58, 66) engages said membrane (17) and deflects said membrane (17) outwardly,
characterized in that a contoured surface (61, 67) having a pattern of ridges engages said membrane (17) such that said contacts (25) on said membrane (17) can be pressed against contacts (65) of said electrical circuit element (63).

2. Device according to claim 1, characterized in that said support form (58, 66) is transparent and said membrane (17) is transparent adjacent said contacts (25) thereon for permitting visual alignment of said contacts (25) on said membrane (17) with said contacts (65) on said electrical circuit element (63) to be tested.

3. Device according to claim 1 or claim 2, characterized in that said surface (61) of said support form (58) defines a ridge (61) that follows the pattern of said predetermined pattern of said contacts (25) on said membrane (17), and is positioned opposite from said contacts (25) on said membrane (17) for concentrating force on said contacts (25) on said membrane (17).

4. Device according to any of claims 1 - 3, characterized in that said surface (67) of said support form (66) has recess means (68) following the pattern of said contacts (25) on said membrane (17), whereby said surface (67) on either side of said recess means (68) can hold said contacts (25) on said membrane (17) for engagement with said contacts (65) of said electrical circuit element (63) to be tested.

5. Device according to any of claims 1 - 4, characterized in that said means (29, 32, 50) for holding said support form (58, 66) in a predetermined fixed position includes mechanical means (32, 50) engaging and holding said support form (58, 66).

6. Device according to any of claims 1 - 5, characterized in that said support form (58) includes flange means (59) projecting outwardly therefrom, and said means (50) for holding said support form (58) in a predetermined fixed position includes means (51, 52, 53) for gripping said flange means (59).

7. Method of constructing a circuit testing device comprising the steps of:
providing a flexible membrane (17),
positioning contact means (25) on one side of said membrane (17) in a pattern corresponding to that of contacts (65) on a device (63) to be tested,
extending conductor means (26) on said membrane (17) for connection to a testing circuit,
holding peripheral portions of said membrane (17) such that intermediate portions of said membrane (17) are unconstrained,
engaging the opposite side of said intermediate portion of said membrane (17) with a member (58, 66) such that said member (58, 66) deflects said membrane (17) outwardly whereby the contact means (25) on said membrane (17) can engage said contacts (65) on said device (63) to be tested and whereby said member (58, 66) is engaged with said membrane (17) at a location opposite from said contact means (25),
characterized by the step of
providing said member (58, 66) with a contoured surface (61, 67) having a pattern of ridges which surface can be engaged with said membrane (17).

8. Method according to claim 7, including the step of contouring said surface (61) such as to provide ridge means (61) directly opposite said contact means (25).

9. Method according to claim 7, including the step of contouring said surface (67) such as to provide ridge means (67) on either side of said contact means (25) and recess means (68) intermediate said ridge means (67).

## Patentansprüche

1. Vorrichtung zum Testen eines elektrischen Schaltungselementes (63), das daran Kontakte (65) in einem vorbestimmten Muster aufweist, mit:
einer Montagevorrichtung (10),
einer Membrananordnung (16), wobei die Membrananordnung (16) aufweist
eine flexible Membran (17),
eine Vielzahl von Kontakten (25) auf einer Seite der Membran (17), deren Position dem Muster der Kontakte (65) an dem elektrischen Schaltungselement (63) entspricht,
Schaltungsmitteln (26) an der Membran (17), die mit den Kontakten (25) verbunden sind und sich von den Kontakten (25) weg erstrecken, um mit einer Testschaltung verbunden zu werden,
Mitteln (19, 29) zum abnehmbaren Positionieren und Lagern der Membrananordnung (16) relativ zu der Montagevorrichtung (10),
einem Lagerformstück (58, 66), das an der gegenüberliegenden Seite der Membran (17) angreift,
Mitteln (29, 32, 50) zum Halten des Lagerformstückes (58, 66) an der Montagevorrichtung (10) in einer vorbestimmten, festgelegten Position, und
Mitteln (64) zum Positionieren des Lagerformstückes (58, 66) derart, daß das Lagerformstück (58, 66) an der Membran (17) angreift und die Membran (17) nach außen auslenkt,
dadurch gekennzeichnet, daß eine Profilfläche (61, 67), die ein Muster von Stegen aufweist, derart an der Membran (17) angreift, daß die Kontakte (25) an der Membran (17) gegen die Kontakte (65) des elektrischen Schaltungselementes (63) gedrückt werden können.

2. Vorrichtung nach Anspruch 1, dadurch gekennzeichnet, daß das Lagerformstück (58, 66) transparent ist und daß die Membran (17) benachbart zu den daran vorgesehenen Kontakten (25) transparent ist, um eine visuell unterstützte Ausrichtung der Kontakte (25) an der Membran (17) mit den Kontakten (65) an dem zu testenden elektrischen Schaltungselement (63) zu gestatten.

3. Vorrichtung nach Anspruch 1 oder Anspruch 2, dadurch gekennzeichnet, daß die Fläche (61) des Lagerformstückes (58) einen Steg (61) definiert, der dem Muster des vorbestimmten Musters von Kontakten (25) an der Membran (17) folgt und gegenüber von den Kontakten (25) an der Membran (17) positioniert ist, um eine Kraft auf die Kontakte (25) an der Membran (17) zu konzentrieren.

4. Vorrichtung nach einem der Ansprüche 1 bis 3, dadurch gekennzeichnet, daß die Fläche (67) des Lagerformstückes (66) Vertiefungsmittel (68) aufweist, die dem Muster der Kontakte (25) an der Membran (17) folgen, wodurch die Fläche (67) auf jeder Seite der Vertiefungsmittel (68) die Kontakte (25) an der Membran (17) so halten kann, daß diese an den Kontakten (65) des zu testenden elektrischen Schaltungselementes (63) angreifen.

5. Vorrichtung nach einem der Ansprüche 1 bis 4, dadurch gekennzeichnet, daß die Mittel (29, .32, 50) zum Halten des Lagerformstückes (58, 66) in einer vorbestimmten, festgelegten Position mechanische Mittel (32, 50) aufweisen, die an dem Lagerformstück (58, 66) angreifen und dieses halten.

6. Vorrichtung nach einem der Ansprüche 1 bis 5, dadurch gekennzeichnet, daß das Lagerformstück (58) Flanschmittel (59) aufweist, die von diesem nach außen vorstehen, und wobei die Mittel (50) zum Halten des Lagerformstückes (58) in einer vorbestimmten, festgelegten Position Mittel (51, 52, 53) zum Ergreifen der Flanschmittel (59) aufweisen.

7. Verfahren zum Konstruieren einer Schaltungstestvorrichtung mit den Schritten:
Bereitstellen einer flexiblen Membran (17),
Positionieren von Kontaktmitteln (25) auf einer Seite der Membran (17) in einem Muster, das jenem von Kontakten (65) an einer zu testenden Vorrichtung (63) entspricht,
Bereitstellen von sich längs erstreckenden Leitermitteln (26) an der Membran (17) zur Verbindung mit einer Testschaltung,
Halten von Umfangsabschnitten der Membran (17) derart, daß mittlere Abschnitte der Membran (17) nicht eingezwängt sind,
man läßt ein Element (58, 66) an der gegenüberliegenden Seite des mittleren Abschnittes der Membran (17) angreifen, derart, daß das Element (58, 66) die Membran (17) nach außen auslenkt, wodurch die Kontaktmittel (25) an der Membran (17) an den Kontakten (65) an der zu testenden Vorrichtung (63) angreifen können, und wobei das Element (58, 66) an der Membran (17) an einem von den Kontaktmitteln (25) gegenüberliegenden Ort angreift,
gekennzeichnet durch den Schritt,
das Element (58, 66) mit einer Profilfläche (61, 67) mit einem Muster von Stegen zu versehen, wobei die Fläche an der Membran (17) angreifen kann.

8. Verfahren nach Anspruch 7, mit dem Schritt, die Fläche (61) derart zu profilieren, daß Stegmittel (61) direkt gegenüberliegend den Kontaktmitteln (25) vorgesehen sind.

9. Verfahren nach Anspruch 7, mit dem Schritt, die Fläche (67) derart zu profilieren, daß Stegmittel (67) auf jeder Seite der Kontaktmittel (25) vorgesehen sind und Vertiefungsmittel (68) zwischen den Stegmitteln (67) vorliegen.

## Revendications

1. Dispositif pour soumettre à des essais un élément (63) de circuit électrique ayant des contacts (65) sur celui-ci dans une configuration prédéterminée comprenant
une armature (10) de montage,
un ensemble (16) à membrane, ledit ensemble (16) à membrane comprenant
une membrane flexible (17),
une pluralité de contacts (25) sur un côté de ladite membrane (17), correspondant en position à la configuration de contacts (65) sur ledit élément (63) de circuit électrique,
un moyen (26) formant circuit sur ladite membrane (17), connecté auxdits contacts (25) et s'étendant à l'écart desdits contacts (25), pour la connexion à un circuit d'essai,
un moyen (19, 29) pour disposer et supporter de manière amovible ledit ensemble (16) à membrane par rapport à ladite armature (10) de montage,
une plate-forme de support (58, 66) coopérant avec le côté opposé de ladite membrane (17),
un moyen (29, 32, 50) pour maintenir ladite plate-forme de support (58, 66) sur ladite armature (10) de montage dans une position fixe prédéterminée, et
un moyen (64) pour positionner ladite plate-forme de support (58, 66) de telle sorte que ladite plate-forme de support (58, 66) coopère avec ladite membrane (17) et défléchit ladite membrane (17) vers l'extérieur,
caractérisé en ce qu'une surface (61, 67) profilée, ayant une configuration nervurée, coopère avec ladite membrane (17) de telle sorte que lesdits contacts (25) sur ladite membrane (17) peuvent être comprimés contre des contacts (65) dudit élément (63) de circuit électrique.

2. Dispositif selon la revendication 1, caractérisé en ce que ladite plate-forme de support (58, 66) est transparente et ladite membrane (17) est transparente et adjacente auxdits contacts (25) sur celle-ci pour permettre un alignement visuel desdits contacts (25) sur ladite membrane (17) avec lesdits contacts (65) sur ledit élément (63) de circuit électrique à soumettre à des essais.

3. Dispositif selon la revendication 1 ou la revendication 2, caractérisé en ce que ladite surface (61) de ladite plate-forme de support (58) définit une nervure (61) qui suit la configuration de ladite configuration prédéterminée desdits contacts (25) sur ladite membrane (17), et est positionnée à l'opposé desdits contacts (25) sur ladite membrane (17) pour concentrer la force sur lesdits contacts (25) sur ladite membrane (17).

4. Dispositif selon l'une quelconque des revendications 1-3, caractérisé en ce que ladite surface (67) de ladite plate-forme de support (66) comporte des moyens (68) à cavité suivant la configuration desdits contacts (25) sur ladite membrane (17), à la suite de quoi ladite surface (67) de chaque côté desdits moyens (68) à cavité peut maintenir lesdits contacts (25) sur ladite membrane (17) pour coopérer avec lesdits contacts (65) dudit élément (63) de circuit électrique à soumettre à des essais.

5. Dispositif selon l'une quelconque des revendications 1-4, caractérisé en ce que ledit moyen (29, 32, 50) pour maintenir ladite plate-forme de support (58, 66) dans une position fixe prédéterminée comporte un moyen mécanique (32, 50) coopérant avec ladite plate-forme de support (58, 66) et la maintenant.

6. Dispositif selon l'une quelconque des revendications 1-5, caractérisé en ce que ladite plate-forme de support (58) comporte un moyen (59) formant rebord faisant saillie à l'extérieur de celle-ci, et ledit moyen (50) pour maintenir ladite plate-forme de support (58) dans une position fixe prédéterminée comporte un moyen (51, 52, 53) pour saisir ledit moyen (59) formant rebord.

7. Procédé de construction d'un dispositif pour soumettre un circuit à des essais, comprenant les étapes suivantes:
fourniture d'une membrane flexible (17),
positionnement de moyens (25) formant contacts sur un côté de ladite membrane (17) dans une configuration correspondant à celle de contacts (65) sur un dispositif (63) à soumettre à des essais,
extension de moyens conducteurs (26) sur ladite membrane (17) pour la connexion à un circuit à soumettre à des essais,
maintien de parties périphériques de ladite membrane (17) de telle sorte que les parties intermédiaires de ladite membrane (17) ne sont pas contraintes,
coopération du côté opposé de ladite partie intermédiaire de ladite membrane (17) avec un élément (58, 66), de telle sorte que ledit élément (58, 66) défléchit ladite membrane (17) vers l'extérieur, à la suite de quoi les moyens (25) formant contacts sur ladite membrane (17) peuvent coopérer avec lesdits contacts (65) sur ledit dispositif (63) à soumettre à des essais, et à la suite de quoi ledit élément (58, 66) coopère avec ladite membrane (17) en un emplacement opposé auxdits moyens (25) formant contact,
caractérisé par l'étape suivante
fourniture audit élément (58, 66) d'une surface profilée (61, 67) ayant une configuration de nervures, cette surface pouvant coopérer avec ladite membrane (17).

8. Procédé selon la revendication 7, comportant le fait de contourner ladite surface (61) de manière à obtenir des moyens (61) à nervure, directement opposés auxdits moyens (25) formant contacts.

9. Procédé selon la revendication 7, comportant le fait de contourner ladite surface (67) de manière à obtenir des moyens (67) à nervure de chaque côté desdits moyens (25) formant contacts et des moyens (68) à cavité entre lesdits moyens (67) à nervure.
